# EUROPÄISCHE PATENTSCHRIFT

(11) **EP 4 200 623 B1**
(45) Veröffentlichungstag und Bekanntmachung des Hinweises auf die Patenterteilung: **23.04.2025**
(21) Anmeldenummer: 21765622.2
(22) Anmeldetag: 17.08.2021
(51) Int. Cl.: G01R 19/175

(54) **VORRICHTUNG UND VERFAHREN ZUR DETEKTION VON WECHSELSPANNUNG**
DEVICE AND METHOD FOR DETECTING AN ALTERNATING VOLTAGE
DISPOSITIF ET PROCÉDÉ POUR DÉTECTER UNE TENSION ALTERNATIVE

(30) Priorität: 18.08.2020 DE 102020121643
(43) Veröffentlichungstag der Anmeldung: 28.06.2023
(73) Patentinhaber: Weidmüller Interface GmbH & Co. KG, 32758 Detmold (DE)
(72) Erfinder: GRÖNE, Niklas, 32676 Lügde (DE); GERKENS, Michael, 33617 Bielefeld (DE)
(74) Vertreter: Kleine, Hubertus
(86) Internationale Anmeldenummer: PCT/EP2021/072851
(87) Internationale Veröffentlichungsnummer: WO 2022/038148

(56) Entgegenhaltungen:
- EP-A2- 2 665 182
- CN-A- 105 098 765
- CN-U- 207 909 743
- US-A- 4 151 464

## Beschreibung

Die Erfindung betrifft eine Vorrichtung zur Detektion von Wechselspannung, aufweisend Eingangsanschlüsse zum Anlegen einer zu detektierenden Wechselspannung und Ausgangsanschlüssen, an denen ein Anliegen der Wechselspannung angezeigt wird. Die Eingangsanschlüsse und die Ausgangsanschlüsse sind dabei durch einen Koppler galvanisch voneinander getrennt, wobei ein Steuerelement des Kopplers von der angelegten Wechselspannung mit Betriebsstrom versorgt wird und ein Schaltelement des Kopplers mit den Ausgangsanschlüssen verbunden ist. Die Erfindung betrifft weiter ein Verfahren zur Detektion von Wechselspannung, das insbesondere mit der genannten Vorrichtung durchführbar ist.

Derartige Vorrichtungen werden genutzt, um in einer elektrischen Installation das Vorhandensein von Wechselspannung an bestimmten Knoten dieser Installation überprüfen zu können, indem die Ausgangsanschlüsse z.B. von einer übergeordneten Überwachungseinrichtung ausgelesen werden. Eine häufige Anwendung ist es, die korrekte Funktionsweise von z.B. Relais bzw. Schützen, Leitungsschutzschaltern, Fehlerstromschutzeinrichtungen oder Lasttrennschaltern zu ermitteln, indem das Vorhandensein der Wechselspannung (ausgangsseitig) an Schaltkontakten detektiert wird und mit dem vorgegebenen Schaltzustand des überprüften Geräts verglichen wird.

Die zu detektierende Wechselspannung ist in der Regel eine Kleinspannung mit einer Spannung von mehr als 60 V, beispielsweise eine Lichtnetz-Spannung. Die übergeordnete Überwachungseinrichtung kann zum Beispiel eine industrielle Automatisierungsanlage sein, die zu Monitoring- oder Steuerungszwecken eingesetzt wird. Die Überwachungseinrichtung kann auch ein Gateway oder ein Datenlogger sein, über das oder den dann nur ein Monitoring erfolgt.

Die Eingänge einer solcher Überwachungseinrichtungen sind in der Regel dazu eingerichtet, ein Schaltsignal zu erfassen oder eine Schutzkleinspannung, zum Beispiel 12 Volt (V) oder 24 V.

Die eingangs genannte Vorrichtung zur Detektion von Wechselspannung gibt die Information über das Vorhandensein der Wechselspannung in Form eines Schaltsignals galvanisch getrennt an die Überwachungseinrichtung weiter, wobei als Koppler in der Regel ein Optokoppler mit einer Leuchtdiode (LED) als Steuerelement zur galvanischen Trennung eingesetzt wird. Die Leuchtdiode des Optokopplers wird dazu von der anliegenden Wechselspannung mit Betriebsstrom versorgt, so dass das Schaltelement des Optokopplers, üblicherweise ein Fototransistor, leitend wird.

In einer einfachsten Ausgestaltung kann eine Serienschaltung aus Gleichrichterdiode und einem Vorwiderstand verwendet werden, um die LED des Optokopplers durch die Wechselspannung zu betreiben. Als Vorwiderstand kann ein ohmscher Widerstand und/oder ein Kondensator mit seinem Wechselstromwiderstand dienen. Zwar wird so ein sehr einfacher Aufbau erzielt, nachteilig fällt jedoch an dem Vorwiderstand der LED für den Optokoppler eine Verlustleistung im Bereich von einigen 10 bis einigen 100 Milliwatt (mW) an, die zu einem energieineffizienten Betrieb der Vorrichtung führt. Zudem detektiert eine derartige Anordnung auch eine eingangsseitige Gleichspannung, was nicht in allen Anwendungsfällen gewünscht ist.

Das Dokument EP 2 665 182 A2 beschreibt einen Nulldurchgangsdetektor mit Eingangsanschlüssen zum Anlegen einer Wechselspannung und mit mittels eines Optokopplers galvanisch getrennten Ausgangsanschlüssen.

Es ist daher eine Aufgabe der vorliegenden Erfindung, eine Vorrichtung und ein Verfahren zur Detektion von Wechselspannung der eingangs genannten Art zu schaffen, die bei einfachem Aufbau und robuster Funktionsweise möglichst energieeffizient mit geringen Verlustleistungen arbeiten und selektiv Wechselspannung erkennen.

Diese Aufgabe wird durch eine Vorrichtung und ein Verfahren mit den jeweiligen Merkmalen der unabhängigen Ansprüche gelöst. Vorteilhafte Ausgestaltungen und Weiterbildungen sind Gegenstand der abhängigen Ansprüche. Eine erfindungsgemäße Vorrichtung der eingangs genannten Art weist einen Nulldurchgangsdetektor für die zu detektierende Wechselspannung auf, der das Steuerelement des Kopplers gepulst mit dem Betriebsstrom versorgt. Erfindungsgemäß arbeitet die Vorrichtung besonders energieeffizient, indem das Schaltelement beim Anliegen der Wechselspannung nicht permanent bestromt ist, sondern mithilfe des Nulldurchgangsdetektors nur kurzzeitig zeitweise bestromt wird. Zudem wird vorteilhaft auf diese Weise nur Wechselstrom detektiert, nicht Gleichstrom. Wenn beispielsweise nach Detektion eines Nulldurchgangs das Schaltelement nur für einen Zeitraum von 10 % der sich an den Nulldurchgang anschließenden Halbwelle der Wechselspannung geschaltet wird, resultiert dieses in einer Ersparnis von 90 % der für das Ansteuern des Schaltelements notwendigen Energie gegenüber einem dauerhaften Ansteuern des Schaltelements.

Beim Verfahren gemäß Anspruch 8 kann der galvanisch trennende Koppler induktiv, kapazitiv oder optisch arbeiten, und insbesondere durch einen Optokoppler gebildet sein. Das Steuerelement ist in dem Fall eine Leuchtdiode.

In einer vorteilhaften Ausgestaltung der Vorrichtung ist dem Nulldurchgangsdetektor ein Eingangsspannungswandler vorgeschaltet, der die Wechselspannung in eine Wechselspannung oder gepulste Gleichspannung mit kleinerem Spannungswert wandelt. Der Nulldurchgangsdetektor lässt sich bei kleinerer Spannung mit geringerem Aufwand aufbauen. Der Eingangsspannungswandler kann einen Gleichrichter mit mindestens einem vorgeschalteten Kondensator und/oder vorgeschaltetem Vorwiderstand aufweisen. Insbesondere durch die genannte Kombination von Gleichrichter, Kondensator und Vorwiderstand lässt sich ein kostengünstiger Spannungswandler mit relativ geringen Verlustleistungen aufbauen. Als Gleichrichter findet dabei bevorzugt mindestens ein Brückengleichrichter Verwendung.

In einer weiteren vorteilhaften Ausgestaltung der Vorrichtung weist der Nulldurchgangsdetektor eine Diode und einen Glättungskondensator auf, um aus der Wechselspannung oder der gepulsten Gleichspannung an seinem Eingang eine Gleichspannung zur Versorgung des Steuerelements zu bilden. Ein Schalttransistor ist mit seiner Schaltstrecke mit dem Steuerelement serienverschaltet, wobei ein Steuereingang des Schalttransistors mit der Wechselspannung oder der gepulsten Gleichspannung am Eingang des Nullspannungswandlers gekoppelt ist. Der Schalttransistor wird dabei so angesteuert, dass er nur im Bereich des Nulldurchgangs durchschaltet.

In einer weiteren vorteilhaften Ausgestaltung der Vorrichtung sind dessen Ausgangsanschlüsse mit den Anschlüssen eines Fototransistors des als Optokoppler ausgeführten Kopplers verbunden. Der (pulsierende) Schaltzustand des Fototransistors kann dann an den Ausgangsanschlüssen abgefragt werden. Dabei ist zu berücksichtigen, dass der Schaltzustand über einen Zeitraum von mindestens einer halben (oder ganzen) Periodendauer der Wechselspannung betrachtet wird, um zu ermitteln, ob Wechselspannung an den Eingangsanschlüssen anliegt. Bei einer digitalen Auswertung des Schaltzustands des Fototransistors über zum Beispiel einen Mikrocontroller kann dieses leicht programmgesteuert umgesetzt werden.

Bei der Vorrichtung gemäß Anspruch 1 ist parallel zu den Anschlüssen des Fototransistors des Optokopplers ein RC-Glied angeordnet.

Durch das RC-Glied wird das an den Ausgangsanschlüssen abgreifbare Signal analog geglättet, wodurch auch ohne Auswertung durch einen Mikrocontroller leicht geschlossen werden kann, ob eine Eingangswechselspannung anliegt oder nicht. In alternativen Ausgestaltungen des Verfahrens können andere Zeitglieder (analog oder digital arbeitende) genutzt werden, um an den Ausgangsanschlüssen ein Signal bereitzustellen, das möglichst konstant einen bestimmten Pegel aufweist, wenn an den Eingangsanschlüssen Wechselspannung anliegt, und das einen davon abweichenden Pegel aufweist, wenn an den Eingangsanschlüssen keine Wechselspannung anliegt.

Ein erfindungsgemäßes Verfahren dient zur Detektion von Wechselspannung mit einer Vorrichtung, die Eingangsanschlüsse zum Anlegen einer zu detektierenden Wechselspannung aufweist und Ausgangsanschlüsse, an denen ein Anliegen der Wechselspannung angezeigt wird. Dabei sind die Eingangsanschlüsse und die Ausgangsanschlüssen durch einen Koppler galvanisch voneinander getrennt, wobei ein Steuerelement des Kopplers von der angelegten Wechselspannung mit Betriebsstrom versorgt wird und ein Schaltelement des Kopplers mit den Ausgangsanschlüssen verbunden ist. Das Verfahren zeichnet sich dadurch aus, dass das Steuerelement des Kopplers gepulst mit dem Betriebsstrom versorgt wird, wobei ein Pulszeitparameter abhängig von einem Nulldurchgang der Wechselspannung ist. Als Pulszeitparameter ist dabei ein Anfangszeitpunkt, ein Endzeitpunkt und/oder eine Pulslänge zu verstehen. Das Verfahren kann z.B. mit der zuvor beschriebenen Vorrichtung durchgeführt werden. Es ergeben sich die im Zusammenhang mit der Vorrichtung angegebenen Vorteile.

Die Erfindung wird nachfolgend anhand von Ausführungsbeispielen mithilfe von Figuren näher erläutert. Die Figuren zeigen:
Figur 1 eine schematisches Blockschaltbild einer Vorrichtung zur Detektion von Wechselspannung; und
Figur 2 eine weitere Vorrichtung zur Detektion von Wechselspannung in einem detaillierteren Schaltbild.

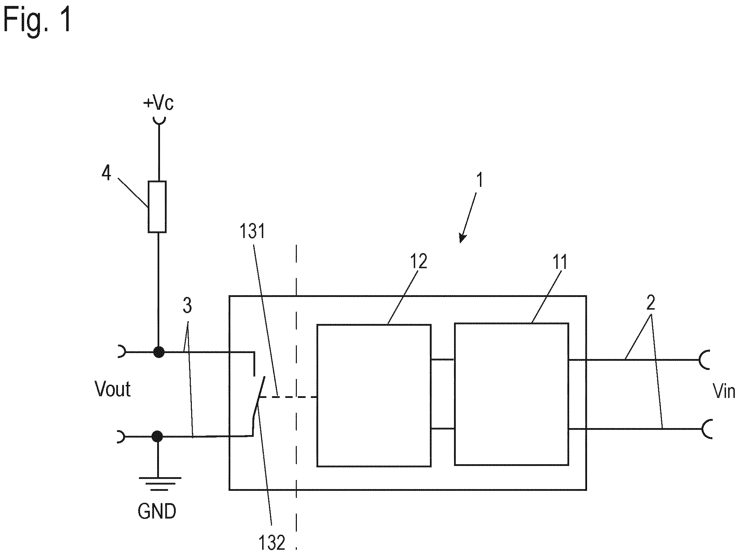

Figur 1 zeigt ein Ausführungsbeispiel einer Vorrichtung 1 zur Detektion von Wechselspannung in einem Blockschaltbild.

Die Vorrichtung 1 weist Eingangsanschlüsse 2 auf, an denen eine zu detektierende Wechselspannung Vin angelegt werden kann. Die Vorrichtung 1 weist weiter zwei potentialfreie Ausgangsanschlüsse 3 auf, die galvanisch von den Eingangsanschlüssen 2 getrennt sind, was in der Figur 1 durch die gestrichelte Linie angedeutet ist.

Über die Ausgangsanschlüsse 3 kann eine übergeordnete Überwachungseinrichtung abfragen, ob an den Eingangsanschlüssen 2 die Wechselspannung Vin anliegt. Durch die galvanische Trennung kann die Abfrage auf einem Spannungsniveau erfolgen, das unabhängig von dem Spannungsniveau der Wechselspannung Vin ist, insbesondere auf dem Niveau einer Kleinst-Gleichspannung. Die Wechselspannung Vin an den Eingangsanschlüssen 2 ist in der Regel eine Wechsel-Kleinspannung mit einem Spannungsniveau von 60 V oder mehr.

Bei dem in Figur 1 gezeigten Beispiel der Vorrichtung 1 sind die Ausgangsanschlüsse mit einem symbolisch als Schalter dargestellten Schaltelement 132 verbunden. Um für die übergeordnete Überwachungseinrichtung ein Spannungssignal zu generieren, ist einer der Ausgangsanschlüsse 3 mit einem Masseanschluss GND gekoppelt und der andere Ausgangsanschluss 3 über einen Pull-Up Widerstand 4 an ein positives Potenzial Vc angeschlossen. Dieses Potenzial Vc kann zum Beispiel von der übergeordneten Überwachungseinrichtung bereitgestellt werden. Bei einer derartigen Ausgestaltung bilden die Ausgangsanschlüsse 3 einen Spannungsausgang, an dem ein Spannung Vout abhängig von der Schalterstellung des Schaltelements 132 anliegt. Bedingt durch die Art der Anordnung des Pull-Up Widerstands 4 ist Vout etwa gleich Vc, wenn das Schaltelement 132 nicht geschaltet ist und etwa gleich null, wenn das Schaltelement 132 leitend geschaltet ist.

Die Vorrichtung 1 kann beispielsweise eingesetzt werden, um zu überprüfen, ob ein von einem Relais oder Schütz, einem Leitungsschutzschalter, einer Fehlerstromschutzeinrichtung oder einem Lasttrennschalter geschalteter Stromversorgungsstrang tatsächlich Spannung führt. Durch einen Vergleich des Spannungssignals Vout mit einem vorgegebenen Schaltzustand des genannten Geräts kann eine korrekte Funktion des Geräts überprüft werden.

Anmeldungsgemäß arbeitet die Vorrichtung 1 besonders energieeffizient, indem das Schaltelement 132 beim Anliegen der Wechselspannung Vin nicht permanent geschaltet ist, sondern mithilfe eines Nulldurchgangsdetektors 12 nur kurzzeitig einmal pro Halbwelle der Wechselspannung Vin leitend geschaltet wird. Beispielsweise kann vorgesehen sein, dass das Schaltelement 132 nur für eine Millisekunde (ms) oder kürzer leitend geschaltet wird, nachdem ein Nulldurchgang detektiert wird. Es wird somit ein Pulszeitparameter, hier der Pulsbeginn, abhängig von einem detektierten Nulldurchgang gemacht. Eine Wechselspannung einer angenommenen Frequenz von 50 Hz hat eine Periodendauer von 20 ms und entsprechend einen Nulldurchgang jede 10 ms. Wenn das Schaltelement 132 dann jeweils nur für beispielsweise 1 ms geschaltet wird, werden nur 10 % der Schaltenergie für das Schaltelement 132 verglichen mit einem kontinuierlichen Schalten benötigt.

Bei dem Beispiel der Figur 1 ist dem Nulldurchgangsdetektor 12 ein Eingangsspannungswandler 11 vorgeschaltet, der die Wechselspannung Vin in eine niedrigere Wechselspannung (oder eine pulsierende Gleichspannung) wandelt. Mit dieser wird dann der Nulldurchgangsdetektor 12 gespeist. Da durch den Eingangsspannungswandler 11 eine Phasenverschiebung eingebracht werden kann, wird das Schaltelement 132 nicht notwendigerweise im Nulldurchgang der Wechselspannung Vin geschaltet, jedoch einmal pro Halbwelle oder einmal pro Periodendauer, je nachdem, ob ein Nulldurchgang bei fallender und steigender Spannung oder nur entweder bei fallender oder steigender Spannung detektiert wird.

Durch den Nulldurchgangsdetektor 12 pulsiert das Signal Vout. Bei einem Erfassen des Signals Vout an den Ausgangsanschlüssen 3 ist das dahingehend zu berücksichtigen, dass länger als eine halbe (oder ganze) Periodendauer der Wechselspannung gemessen wird, ob das Signal Vout gleich null ist. Wenn das Signal Vout zu irgendeinem Zeitpunkt innerhalb einer Zeitdauer von mehr als einer halben (oder ganzen) Periodendauer gleich null ist, liegt die Wechselspannung Vin an. Nur wenn für mindestens eine halbe (bzw. ganze) Periodendauer ein von null verschiedenes Signal Vout erkannt wird, kann gefolgert werden, dass keine Wechselspannung Vin an den Eingangsanschlüssen 2 anliegt. Bei Auswertung des Signals Vout als Digitalsignal über zum Beispiel einen Mikrocontroller kann dieses leicht programmgesteuert erfasst werden.

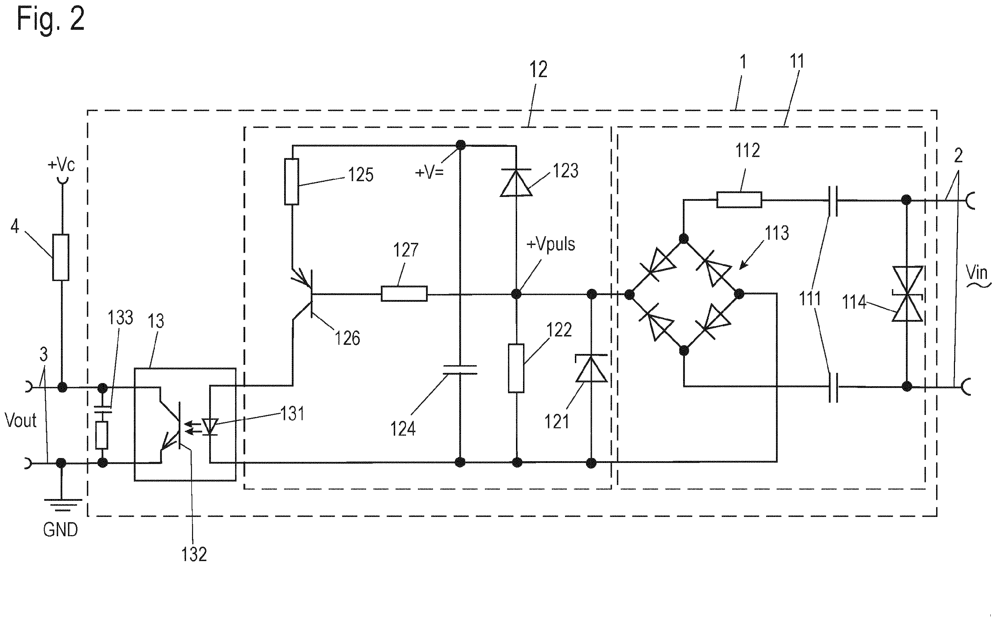

In einer alternativen Ausgestaltung kann an den Ausgangsanschlüssen 3 ein RC-Glied mit einer an die Periodendauer der Eingangswechselspannung Vin angepassten Zeitkonstante angeordnet sein, die eine Glättung des Signals Vout vornimmt. Beim Anliegen der Wechselspannung Vin sinkt das Signal Vout dann mit der Zeitkonstante auf einen Minimalwert nahe null ab. Liegt die Wechselspannung Vin nicht mehr an, steigt das Signal Vout mit dieser Zeitkonstante auf einen Maximalwert nahe Vc. Ein Ausführungsbeispiel, in dem ein entsprechendes RC-Glied bereits in die Vorrichtung 1 integriert ist, ist in der Figur 2 gezeigt.

Figur 2 zeigt ein zweites Ausführungsbeispiel einer Überwachungsvorrichtung 1 in einem detaillierteren Schaltbild als Figur 1. Bis auf das zuvor angesprochene RC-Glied kann der Schaltungsaufbau der Figur 2 auf das Ausführungsbeispiel der Figur 1 übertragen werden. Die externe Schaltung der Vorrichtung 1 ist bei der Figur 2 analog zu der der Figur 1.

Bei der Vorrichtung 1 gemäß Figur 2 ist der Koppler 13 beispielhaft ein Optokoppler, der nachfolgend auch als Optokoppler 13 bezeichnet wird. Das Schaltelement 132 ist ein Fototransistor des Optokopplers 13. Parallel zur Schaltstrecke des Fototransistor ist ein RC-Glied 133 geschaltet, das der Glättung des Ausgangssignals Vout dient und einen Kondensator und einen Widerstand in Serienschaltung umfasst. Alternativ zu dem Optokoppler 13 kann auch ein auf einem anderen Übertragungsprinzip arbeitender Koppler eingesetzt werden, beispielsweise ein induktiv oder kapazitiv arbeitender Koppler.

Der Optokoppler 13 weist eine Leuchtdiode (LED) als Steuerelement 131 auf, die bei Stromfluss den Fototransistor, also die Schaltstrecke 132, leitend schaltet. Das Steuerelement 131 wird nachfolgend auch als LED 131 bezeichnet. Die LED 131 wird über einen Nulldurchgangsdetektor 12 pulsierend mit Betriebsstrom versorgt. Dem Nulldurchgangsdetektor 12 ist ein Eingangsspannungswandler 11 als Eingangsstufe vorgeschaltet, der von der angelegten Wechselspannung Vin versorgt wird.

Der Eingangsspannungswandler 11 ist vorliegend in Art eines Kondensatornetzteils aufgebaut. Er weist vorliegend zwei Kondensatoren 111 auf, die in Reihenschaltung mit einem Vorwiderstand 112 und einer Brückengleichrichter 113 unmittelbar mit den Eingangsanschlüssen 2 verbunden sind. Alternativ kann anstelle der Kombination von Kondensatoren und Widerstand auch eine Anordnung mit einem oder mehreren Widerständen ohne Kondensator eingesetzt werden. Mehrere Widerstände können als Spannungsteiler oder kaskadenartig verschaltet sein. Ein nur mit Widerständen ausgeführter Eingangsspannungswandler ist zwar etwas verlustbehafteter, weist aber eine hohe Überspannungsfestigkeit auf. Eine optionale, parallel zu den Eingangsanschlüssen 2 geschalteten Suppressordiode dient als Schutzelement 114 vor kurzzeitigen hohen Spannungsimpulsen an den Eingangsanschlüssen 2.

Parallel zu Ausgängen des Brückengleichrichter 113 sind eine Zener-Diode 121 und ein Widerstand 122 geschaltet. An dieser Parallelschaltung liegt eine pulsierende Spannung Vpuls an, deren Zeitverlauf aneinandergereihten Halbwellen der Wechselspannung Vin entspricht, wobei negative Halbwellen jeweils durch den Brückengleichrichter 113 "hochgeklappt" sind. Die Spannung Vpuls ist über eine Diode 123 auf einen Glättungskondensator 124 gelegt, der sich entsprechend auf eine Gleichspannung V= auflädt, deren Höhe der Amplitude der Spannung Vpuls entspricht.

Der Kondensator 124 ist über einen Vorwiderstand 125 und einen Transistor 126 mit der LED 131 des Optokopplers 13 verbunden. Der Transistor 126 ist im dargestellten Beispiel ein PNP-Bipolartransistor, dessen Steuereingang über einen weiteren Vorwiderstand 127 mit dem Knoten, an dem die pulsierende Spannung Vpuls anliegt, verbunden ist.

Wenn an diesem Knoten eine positive Spannung anliegt, also während einer Halbwelle der pulsierenden Spannung Vpuls, sperrt der Transistor 126 und der Kondensator 124 lädt sich auf die Spannung V= auf. Sobald die Spannung Vpuls auf einen Wert nahe null fällt, wird der Transistor 126 leitend und der Kondensator 124 entlädt sich über den Vorwiderstand 125, den Transistor 126 und die LED 131, die entsprechend aufleuchtet und das Schaltelement 132 leitend schaltet. Sobald die Spannung Vpuls wieder ansteigt, sperrt der Transistor 126 erneut und die LED 131 erlischt. Dieses gilt zumindest, wenn die Kapazität des Glättungskondensators 124 so groß ist, dass der Glättungskondensator 124 die LED 131 mit Betriebsstrom versorgen kann, bis der Transistor 126 wieder sperrt. Die Kapazität des Glättungskondensators 124 kann auch so gewählt sein, dass die Leuchtdauer der LED 131 durch die gespeicherte Energie im Glättungskondensator 124 begrenzt ist und die LED 131 bereits erloschen ist, wenn der Transistor 126 wieder über seinen Steuereingang gesperrt wird.

In jedem Fall wird die Leuchtdauer der LED 131 kurz verglichen mit der halben Periodendauer der Wechselspannung Vin sein. Wie im Zusammenhang mit Figur 1 ausgeführt ist, kann eine Leuchtdauer im Bereich von Millisekunden oder darunter eingestellt sein.

Während die LED 131 leuchtet, wird der Fototransistor (Schaltelement 132) leitend und entlädt den Kondensator des RC-Glieds 133. An den Ausgangsanschlüssen 3 stellt sich dann eine minimale Spannung Vout ein, die das Vorliegen der Wechselspannung Vin anzeigt. Leuchtet die LED 131 eine längere Zeit (einige Periodendauern) nicht, steigt die Spannung Vout an den Ausgangsanschlüssen 3 an, was anzeigt, dass keine Wechselspannung Vin an den Eingangsanschlüssen 2 anliegt.

### Bezugszeichenliste

- 1: Überwachungsvorrichtung
- 2: Eingangsanschluss
- 3: Ausgangsanschluss
- 4: Pull-Up Widerstand

- 11: Eingangsspannungswandler
- 111: Kondensator
- 112: Vorwiderstand
- 113: Brückengleichrichter
- 114: Schutzelement

- 12: Nulldurchgangsdetektor
- 121: Zenerdiode
- 122: Widerstand
- 123: Diode
- 124: Glättungskondensator
- 125: Vorwiderstand
- 126: Schalttransistor
- 127: Vorwiderstand

- 13: Koppler / Optokoppler
- 131: Steuerelement / Leuchtdiode (LED)
- 132: Schaltelement
- 133: Glättungskondensator

- Vin: Wechselspannung
- Vout: Ausgangssignal
- Vc: Versorgungsspannung
- V=: Gleichspannung
- Vpuls: gepulste Gleichspannung

## Patentansprüche

1. Vorrichtung (1) zur Detektion von Wechselspannung, aufweisend Eingangsanschlüsse (2) zum Anlegen einer zu detektierenden Wechselspannung (Vin) und Ausgangsanschlüsse (3), an denen ein Anliegen der Wechselspannung (Vin) angezeigt wird, wobei die Eingangsanschlüsse (2) und die Ausgangsanschlüssen (3) durch einen als Optokoppler ausgebildeten Koppler (13) galvanisch voneinander getrennt sind und wobei eine Leuchtdiode als Steuerelement (131) des Kopplers (13) von der angelegten Wechselspannung mit Betriebsstrom versorgt wird und ein Schaltelement (132) des Kopplers (13) mit den Ausgangsanschlüssen (3) verbunden ist, **dadurch gekennzeichnet, dass**
die Vorrichtung (1) einen Nulldurchgangsdetektor (12) für die zu detektierende Wechselspannung (Vin) aufweist, der das Steuerelement (131) des Kopplers (13) gepulst mit dem Betriebsstrom versorgt, und dass parallel zu den Anschlüssen des Fototransistors des Optokopplers (13) ein RC-Glied (133) derart angeordnet ist, dass es das an den Ausgangsanschlüssen abgreifbare Signal analog glättet.

2. Vorrichtung (1) nach Anspruch 1, bei der dem Nulldurchgangsdetektor (12) ein Eingangsspannungswandler (11) vorgeschaltet ist, der die Wechselspannung (Vin) in eine Wechselspannung oder gepulste Gleichspannung (Vpuls) mit kleinerem Spannungswert wandelt.

3. Vorrichtung (1) nach Anspruch 2, bei der der Eingangsspannungswandler (11) einen Gleichrichter mit mindestens einem vorgeschalteten Kondensator (111) und/oder vorgeschaltetem Vorwiderstand (112) aufweist.

4. Vorrichtung (1) nach Anspruch 3, bei der der Gleichrichter der Eingangsspannungswandler (11) mindestens ein Brückengleichrichter (113) ist.

5. Vorrichtung (1) nach einem der Ansprüche 1 bis 4, bei der der Nulldurchgangsdetektor (12) eine Diode (123) und einen Glättungskondensator (124) aufweist, um aus der Wechselspannung oder gepulste Gleichspannung (Vpuls) an seinem Eingang eine Gleichspannung (V=) zur Versorgung des Steuerelements (131) zu bilden.

6. Vorrichtung (1) nach einem der Ansprüche 1 bis 5, bei der der Nulldurchgangsdetektor (12) einen Schalttransistor (126) aufweist, dessen Schaltstrecke mit dem Steuerelement (131) serienverschaltet ist und dessen Steuereingang mit der Wechselspannung oder der gepulsten Gleichspannung (Vpuls) an seinem Eingang gekoppelt ist.

7. Vorrichtung (1) nach einem der Ansprüche 1 bis 6, bei der die Ausgangsanschlüsse (3) mit den Anschlüssen eines Fototransistors des als Optokoppler ausgeführten Kopplers (13) verbunden sind.

8. Verfahren zur Detektion von Wechselspannung, mit einer Vorrichtung, die Eingangsanschlüsse (2) zum Anlegen einer zu detektierenden Wechselspannung (Vin) aufweist und Ausgangsanschlüsse (3), an denen ein Anliegen der Wechselspannung (Vin) angezeigt wird, wobei die Eingangsanschlüsse (2) und die Ausgangsanschlüssen (3) durch ein Koppler (13) galvanisch voneinander getrennt sind und wobei ein Steuerelement (131) des Kopplers (13) von der angelegten Wechselspannung mit Betriebsstrom versorgt wird und ein Schaltelement (132) des Kopplers (13) mit den Ausgangsanschlüssen (3) verbunden ist, **dadurch gekennzeichnet, dass** das Steuerelement (131) des Kopplers (13) gepulst mit dem Betriebsstrom versorgt wird, wobei ein Pulszeitparameter abhängig von einem Nulldurchgang der Wechselspannung (Vin) ist.

9. Verfahren nach Anspruch 8, bei dem der Pulszeitparameter ein Zeitpunkt eines Beginns eines der Pulse, ein Zeitpunkt eines Endes eines der Pulse und/oder eine Länge der Pulse ist.

## Claims

1. A device (1) for detecting alternating voltage, comprising input terminals (2) for the application of an alternating voltage (Vin) to be detected and output terminals (3), at which application of the alternating voltage (Vin) is indicated, wherein the input terminals (2) and the output terminals (3) are galvanically separated from each other by means of a coupler (13) which is designed as an optocoupler, and wherein a light-emitting diode as a control element (131) of the coupler (13) is supplied with operating current from the applied alternating voltage, and a switching element (132) of the coupler (13) is connected to the output terminals (3), **characterized in that** the device (1) has a zero-crossing detector (12) for the alternating voltage (Vin) to be detected, which zero-crossing detector supplies the control element (131) of the coupler (13) with the operating current in pulses, and **in that** an RC element (133) is arranged parallel to the terminals of the phototransistor of the optocoupler (13) in such a way that it smoothes the signal which can be tapped at the output terminals in an analog manner.

2. The device (1) according to claim 1, in which an input voltage converter (11), which converts the alternating voltage (Vin) into an alternating voltage or pulsed direct voltage (Vpuls) with smaller voltage value, is connected upstream of the zero-crossing detector (12).

3. The device (1) according to claim 2, in which the input voltage converter (11) has a rectifier with at least one capacitor (111) connected upstream and/or series resistor (112) connected upstream.

4. The device (1) according to claim 3, in which the rectifier of the input voltage converter (11) is at least one bridge rectifier (113).

5. The device (1) according to any one of claims 1 to 4, in which the zero-crossing detector (12) has a diode (123) and a smoothing capacitor (124), in order to form, from the alternating voltage or pulsed direct voltage (Vpuls), at its input, a direct voltage (V=) for supplying the control element (131).

6. The device (1) according to any one of claims 1 to 5, in which the zero-voltage detector (12) has a switching transistor (126), whose switching path is connected in series with the control element (131) and whose control input is coupled to the alternating voltage or the pulsed direct voltage (Vpuls) at its input.

7. The device (1) according to any one of claims 1 to 6, in which the output terminals (3) are connected to the terminals of a phototransistor of the coupler (13) which is designed as an optocoupler.

8. A method for detecting alternating voltage, with a device which has input terminals (2) for the application of an alternating voltage (Vin) to be detected and output terminals (3), at which application of the alternating voltage (Vin) is indicated, wherein the input terminals (2) and the output terminals (3) are galvanically separated from each other by means of a coupler (13), and wherein a control element (131) of the coupler (13) is supplied with operating current from the applied alternating voltage, and a switching element (132) of the coupler (13) is connected to the output terminals (3), **characterized in that** the control element (131) of the coupler (13) is supplied with the operating current in pulses, wherein a pulse time parameter is dependent upon a zero cross of the alternating voltage (Vin).

9. The method according to claim 8, in which the pulse time parameter is a point in time of a beginning of one of the pulses, a point in time of an end of one of the pulses and/or a length of the pulses.

## Revendications

1. Dispositif (1) pour la détection d'une tension de courant alternatif, comprenant des branchements d'entrée (2) pour l'application d'une tension de courant alternatif à détecter (Vin) et des branchements de sortie (3) sur lesquels une application de la tension de courant alternatif (Vin) est indiquée, dans lequel les branchements d'entrée (2) et les branchements de sortie (3) sont séparés galvaniquement les uns des autres par un coupleur (13) conformé comme un optocoupleur et dans lequel une diode électroluminescente servant d'élément de commande (131) du coupleur (13) est alimentée en courant de fonctionnement par la tension de courant alternatif appliquée et un élément de commutation (132) du coupleur (13) est connecté aux branchements de sortie (3), **caractérisé en ce que** le dispositif (1) comprend un détecteur de passage à zéro (12) pour la tension de courant alternatif à détecter (Vin), qui alimente l'élément de commande (131) du coupleur (13) en courant de fonctionnement en impulsions, et **en ce qu'**un élément RC (133) est disposé en parallèle aux branchements du phototransistor de l'optocoupleur (13), de telle manière qu'il lisse de façon analogique le signal pouvant être capté sur les branchements de sortie.

2. Dispositif (1) selon la revendication 1, dans lequel est monté en amont du détecteur de passage à zéro (12) un convertisseur de tension d'entrée (11) qui convertit la tension de courant alternatif (Vin) en tension de courant alternatif ou en tension de courant continu en impulsions (Vpuls) ayant une valeur de tension plus basse.

3. Dispositif (1) selon la revendication 2, dans lequel le convertisseur de tension d'entrée (11) comprend un redresseur et au moins un condensateur (111) monté en amont et/ou une résistance d'amont (112) montée en amont.

4. Dispositif (1) selon la revendication 3, dans lequel le redresseur des convertisseurs de tension d'entrée (11) est au moins un redresseur à pont (113).

5. Dispositif (1) selon l'une des revendications 1 à 4, dans lequel le détecteur de passage à zéro (12) comprend une diode (123) et un condensateur de lissage (124) afin de former à son entrée, à partir de la tension de courant alternatif ou de la tension de courant continu en impulsions (Vpuls), une tension de courant continu (V=) pour alimenter l'élément de commande (131).

6. Dispositif (1) selon l'une des revendications 1 à 5, dans lequel le détecteur de passage à zéro (12) comprend un transistor de commutation (126) dont les triangles de commutation sont montés en série avec l'élément de commande (131) et dont l'entrée de commande est couplée avec la tension de courant alternatif ou la tension de courant continu en impulsions (Vpuls) à son entrée.

7. Dispositif (1) selon l'une des revendications 1 à 6, dans lequel les branchements de sortie (3) sont connectés aux branchements d'un phototransistor du coupleur (13) réalisé comme un optocoupleur.

8. Procédé pour la détection d'une tension de courant alternatif, avec un dispositif qui comporte des branchements d'entrée (2) pour l'application d'une tension de courant alternatif à détecter (Vin) et des branchements de sortie (3), sur lesquels une application de la tension de courant alternatif (Vin) est indiquée, dans lequel les branchements d'entrée (2) et les branchements de sortie (3) sont séparés galvaniquement les uns des autres par un coupleur (13) et dans lequel l'élément de commande (131) du coupleur (13) est alimenté en courant de fonctionnement par la tension de courant alternatif appliquée, **caractérisé en ce que** l'élément de commande (131) du coupleur (13) est alimenté en courant de fonctionnement en impulsions, un paramètre de durée des impulsions étant dépendant d'un passage à zéro de la tension de courant alternatif (Vin).

9. Procédé selon la revendication 8, dans lequel le paramètre de durée des impulsions est un instant de début d'une des impulsions, un instant de fin d'une des impulsions et/ou une longueur des impulsions.
